# EUROPEAN PATENT APPLICATION

(11) **EP 4 407 771 A2**
(43) Date of publication of application: **31.07.2024**
(21) Application number: 23217528.1
(22) Date of filing: 18.12.2023
(51) Int. Cl.: H01M 50/284, H01L 23/58, H01M 50/519, H05K 1/18, H05K 7/10

(54) **RECHARGEABLE BATTERY PACK**

(30) Priority: 17.01.2023 KR 20230007008
(71) Applicant: Samsung SDI Co., Ltd., Yongin-si, Gyeonggi-do 17084 (KR)
(72) Inventor: AHN, Jaepil, 17084 Yongin-si (KR)
(74) Representative: Marks & Clerk LLP

(57) **Abstract**

A rechargeable battery pack includes a cell assembly including at least one battery cell, a frame portion accommodating the cell assembly, a flexible printed circuit (FPC) electrically connected to the cell assembly and configured to sense at least one property of the battery cell, and a dual-in-line plug (DIP) connector electrically connected to the flexible printed circuit on a first side of the frame portion. The flexible printed circuit and the DIP connector are electrically connected to each other by an electrically conductive adhesive.

## Description

### BACKGROUND

### 1. Field

The present disclosure relates to a rechargeable battery pack.

### 2. Description of the Related Art

A rechargeable battery can be repeatedly charged and discharged, unlike a primary battery. Small-capacity rechargeable batteries are used in small portable electronic devices such as mobile phones, notebook computers, and camcorders. High-capacity and high-density rechargeable batteries are used for power or energy storage for driving motors in hybrid vehicles and electric vehicles.

A rechargeable battery includes an electrode assembly for charging and discharging current, a case for accommodating the electrode assembly and an electrolyte solution, and an electrode terminal connected to the electrode assembly that extends out of the case. The electrode assembly may be formed in a jelly roll type formed by winding an electrode and a separator.

Additionally, a conventional flexible printed circuit (FPC) is electrically connected to a dual-in-line plug (DIP) connector using a terminal such as a connector.

However, in the process of connecting the flexible printed circuit and the DIP connector using a terminal such as a connector, circuit damage frequently occurs, resulting in decreased durability.

### SUMMARY

The present disclosure provides a rechargeable battery pack that achieves an electrical connection between a dual-in-line plug (DIP) connector and a flexible printed circuit by using an electrically conductive adhesive without using a terminal such as a connector.

A rechargeable battery pack includes a cell assembly including at least one battery cell, a frame portion accommodating the cell assembly, a flexible printed circuit (FPC) electrically connected to the cell assembly, and configured to sense at least one property of the battery cell, and a dual-in-line plug (DIP) connector electrically connected to the flexible printed circuit on a first side of the frame portion. The flexible printed circuit and the DIP connector are electrically connected to each other by an electrically conductive adhesive.

The electrically conductive adhesive may be a solder or conductive glue that electrically connects the flexible printed circuit and the DIP connector.

The DIP connector may include a number (e.g., plurality) of circuit lines and a number (e.g., plurality) of conductive pad portions at end portions of the circuit lines. The number (e.g., plurality) of conductive pad portions may be electrically connected to the flexible printed circuit by the electrically conductive adhesive.

A (e.g., at least one) conductive pad portion of the number (e.g., plurality) of conductive pad portions may include a first expansion pad protruding from a first side of a width direction of a circuit line of the number (e.g., plurality) of circuit lines, and a second expansion pad protruding from a second side of the width direction of the circuit line.

The first expansion pad and the second expansion pad may protrude from an end portion of the circuit line, in a round shape in directions facing each other.

A first round hole may be formed between the first expansion pad and the second expansion pad.

The electrically conductive adhesive may be solder in the first round hole.

The electrically conductive adhesive may be wire solder in the first round hole.

The rechargeable battery pack may further include a first groove in the DIP connector, and the conductive pad portion may be in the first groove.

A rear side surface of the DIP connector may be in surface contact with a surface of the flexible printed circuit, and the first groove may be formed on a first side surface of the DIP connector.

The rechargeable battery pack may further include a fixing pad portion fixing the flexible printed circuit and the DIP connector to each other.

The rechargeable battery pack may further include a second groove at opposite sides of a width direction of the DIP connector. The fixing pad portion may be in the second groove.

The fixing pad portion may fix the flexible printed circuit and the DIP connector by the electrically conductive adhesive at a portion where the circuit lines are not formed.

The fixing pad portion may include a first pad in the first groove, and a second pad in the second groove.

The rechargeable battery pack may further include a second round hole in the first pad that has a first curvature.

The rechargeable battery pack may further include a third round hole in the second pad that has a second curvature different from the first curvature.

The rechargeable battery pack may further include, in at least one circuit line among the number (e.g., plurality) of circuit lines formed in the DIP connector, a sub-pad portion at a position spaced apart from the conductive pad portion and electrically interconnecting the DIP connector and the flexible printed circuit.

The rechargeable battery pack may further include a through hole in an interior of the sub-pad portion into which the electrically conductive adhesive is inserted, and the (e.g., the at least one) circuit line may protrude to both sides in in the width direction.

The rechargeable battery pack may further include a gas discharging portion in the DIP connector spaced apart from the conductive pad portion.

The gas discharging portion may include a third pad connected to the number (e.g., plurality) of circuit lines on a side surface of the conductive pad portion.

The third pad may be at a position of the side surface of the conductive pad portion, and the third pad may have a width larger than a width of each of the circuit lines.

The gas discharging hole may penetrate both the third pad and the DIP connector.

A conformal coating may be on a surface of the electrically conductive adhesive.

The conformal coating may cover the conductive pad portion around the first groove of the DIP connector.

At least some of the above and other features of the invention are set out in the claims.

According to an embodiment, a flexible printed circuit and a DIP connector are electrically connected by using an electrically conductive adhesive such as a solder without using a separate terminal, and thus disconnection at the connection portion of the circuit due to compression damage may be prevented.

### BRIEF DESCRIPTION OF THE DRAWINGS

FIG. 1 is a perspective view schematically illustrating a rechargeable battery pack according to a first embodiment of the present disclosure.
FIG. 2 is a perspective view schematically illustrating a state that a conductive pad portion and a fixing pad portion are formed at an interconnection location of a flexible printed circuit and a dual-in-line plug (DIP) connector according to a first embodiment of the present disclosure.
FIG. 3 is a top plan view schematically illustrating a configuration in which a conductive pad portion and a fixing pad portion are formed at an interconnection location of a flexible printed circuit and a DIP connector of FIG. 2.
FIG. 4 schematically illustrates a configuration in which a flexible printed circuit and a DIP connector of FIG. 3 are electrically interconnected to each other by electrically conductive adhesive (e.g., solder).
FIG. 5 schematically illustrates a configuration in which an electrically conductive adhesive is omitted from a conductive pad portion of a first groove of FIG. 3.
FIG. 6 schematically illustrates a configuration in which a first pad of a fixing pad portion is formed on side surface of a conductive pad portion of a first groove of FIG. 3.
FIG. 7 is a perspective view schematically illustrating a configuration in which a conductive pad portion and a sub-pad portion are formed at an interconnection location of a flexible printed circuit and a DIP connector according to a second embodiment of the present disclosure.
FIG. 8 is a top plan view schematically illustrating a configuration in which a conductive pad portion and a sub-pad portion are formed at an interconnection location of a flexible printed circuit and a DIP connector of FIG. 7.
FIG. 9 is a perspective view schematically illustrating a configuration in which a conductive pad portion and a gas discharging portion are formed at an interconnection location of a flexible printed circuit and a DIP connector according to a third embodiment of the present disclosure.
FIG. 10 is a top plan view schematically illustrating a configuration in which a conductive pad portion and a gas discharging portion are formed at an interconnection location of a flexible printed circuit and a DIP connector of FIG. 9.

### DETAILED DESCRIPTION

Hereinafter, the present invention will be described more fully with reference to the accompanying drawings, in which embodiments of the invention are shown. As those skilled in the art would realize, the described embodiments may be modified in various different ways, all without departing from the scope of the present invention. The drawings and description are to be regarded as illustrative in nature and not restrictive. Like reference numerals designate like elements throughout the specification.

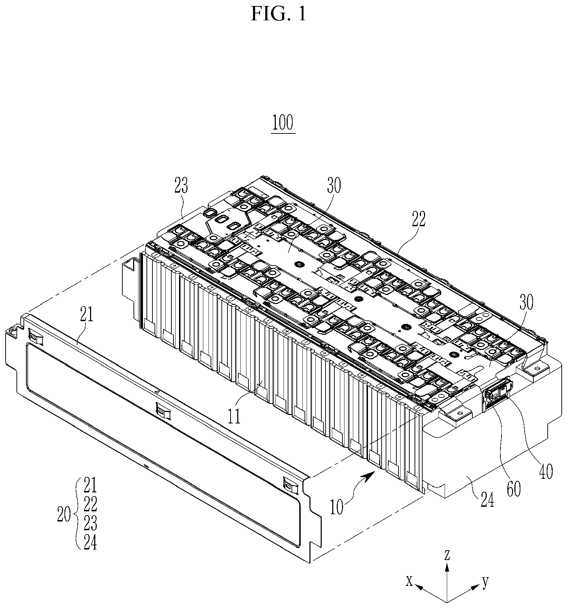

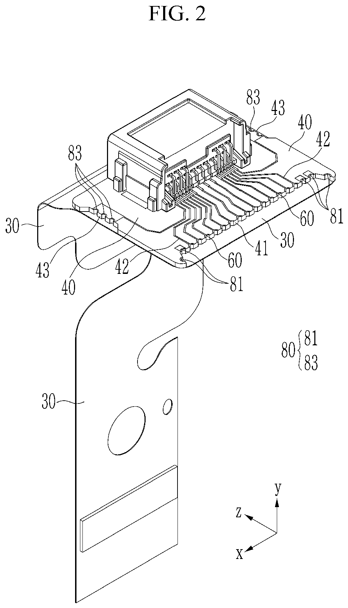

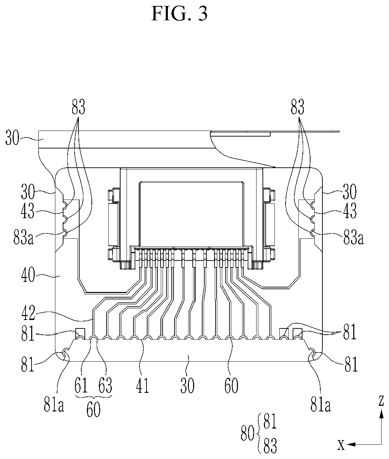

FIG. 1 is a perspective view schematically illustrating a rechargeable battery pack according to a first embodiment of the present disclosure. FIG. 2 is a perspective view schematically illustrating a configuration in which a conductive pad portion and a fixing pad portion are formed at an interconnection location of a flexible printed circuit and a dual-in-line plug (DIP) connector according to a first embodiment of the present disclosure. FIG. 3 is a top plan view schematically illustrating a configuration in which a conductive pad portion and a fixing pad portion are formed at an interconnection location of a flexible printed circuit and a DIP connector of FIG. 2.

As shown in FIG. 1 to FIG. 3, a rechargeable battery pack 100 according to a first embodiment of the present disclosure includes a cell assembly 10 including at least one battery cell 11, a frame portion 20 accommodating the cell assembly 10, a flexible printed circuit (FPC) 30 electrically connected to the cell assembly 10 and configured to sense or detect at least one property of the battery cell 11, and a DIP connector 40 electrically connected to the flexible printed circuit 30 and installed on a first side of the frame portion 20.

A plurality of battery cells 11 may be composed of ordinary rechargeable batteries that are configured to repeatedly perform charging and discharging operations.

The frame portion 20 may include a first side frame 21 configured to support a first side surface of a plurality of battery cells 11, a second side frame 22 configured to support a second side surface of the plurality of battery cells 11, a first end frame 23 having ends connected to respective first ends of the first side frame 21 and the second side frame 22, and a second end frame 24 having ends connected to respective second ends of the first side frame 21 and the second side frame 22.

The first side frame 21 may be installed to support first sides of the plurality of battery cells 11.

The second side frame 22 may be installed to support second sides of the plurality of battery cells 11.

The first end frame 23 may be installed to connect between the first ends of the first side frame 21 and the second side frame 22. That is, a first end of the first end frame 23 may be connected to a first end of the first side frame 21 by a fastening member, and a second end thereof may be connected to a first end of the second side frame 22 by a fastening member.

The second end frame 24 may be installed to connect between the second ends of the first side frame 21 and the second side frame 22. That is, a first end of the second end frame 24 may be connected to a second end of the first side frame 21 by a fastening member, and a second end of the second end frame 24 may be connected to a second end of the second side frame 22 by a fastening member.

The flexible printed circuit (FPC) 30, which is electrically connected to the cell assembly 10 and is configured to sense or determine at least one property of the battery cell 11, may be installed in an upper portion of the frame portion 20.

The flexible printed circuit 30 may be installed to sense or determine voltage, temperature, or the like, of the battery cell 11.

A plurality of circuit lines 42 of the flexible printed circuit 30 may be electrically connected to the DIP connector 40 at a side surface of the frame portion 20.

The DIP connector 40 is installed on a first side position of the cell assembly 10, and in the present embodiment, may be installed at a location of the second end frame 24, to be electrically connected to the flexible printed circuit 30. The present disclosure is not limited to the DIP connector 40 being installed at a location of the second end frame 24, and in one or more embodiments the installation position of the DIP connector 40 may depend on the position of the first end frame 23 or the like.

The DIP connector 40 and the flexible printed circuit 30 are electrically interconnected to each other by an electrically conductive adhesive 50.

That is, the DIP connector 40 and the flexible printed circuit 30 are electrically connected to each other by using an electrically conductive adhesive such as a solder without using a separate terminal, and thus disconnection at the connection portion of the circuit due to compression damage may be prevented.

In one or more embodiments, the electrically conductive adhesive 50 may be applied as a solder to electrically connect the flexible printed circuit 30 and the DIP connector 40. In one or more embodiments, the electrically conductive adhesive 50 may be applied as a conductive glue. Hereinafter, application of solder as the electrically conductive adhesive 50 will be described as an example, and the same reference numeral will be used for the electrically conductive adhesive and the solder in the following description.

A conductive pad portion 60 for bonding the solder 50 may be formed on the DIP connector 40. To this end, a first groove 41 for connection to the flexible printed circuit 30 and the conductive pad portion 60 may be formed in the DIP connector 40.

The rear side of the DIP connector 40 is installed in a configuration in which it is in surface contact with a surface of the flexible printed circuit 30, and the first groove 41 may be formed on the first side surface of the DIP connector 40.

The first groove 41 is formed at an edge of the first side of the DIP connector 40 and may be formed to extend from the first side of the DIP connector 40 toward the inside.

The conductive pad portion 60 connected to the circuit line 42 formed in the DIP connector 40 may be formed in the first groove 41.

Therefore, the flexible printed circuit 30 may be electrically connected to the DIP connector 40 by the conductive pad portion 60 formed at the edge of the first groove 41.

That is, the conductive pad part 60 is a portion that is formed at the edge of the first groove 41 formed in the DIP connector 40 and to which the solder 50 is bonded, and may electrically connect the flexible printed circuit 30 to a circuit line 31 of the DIP connector 40.

The conductive pad portion 60 protrudes from the circuit line 42 in a size larger than the width of the circuit line 42, and thus may electrically interconnect the flexible printed circuit 30 and the DIP connector 40 by the solder 50.

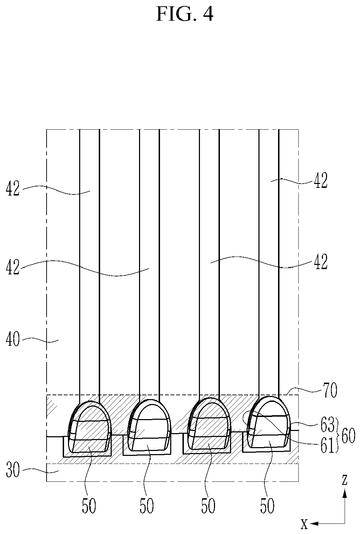

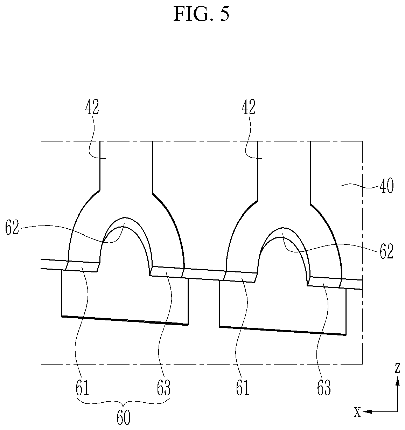

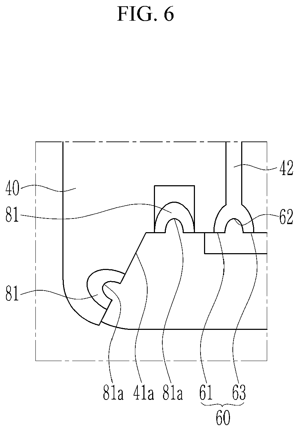

FIG. 4 schematically illustrates a configuration in which the flexible printed circuit and the DIP connector of FIG. 3 are electrically interconnected to each other by electrically conductive adhesive (e.g., solder). FIG. 5 schematically illustrates a configuration in which an electrically conductive adhesive is omitted from a conductive pad portion of a first groove of FIG. 3. FIG. 6 schematically illustrates a configuration in which a first pad of a fixing pad portion is formed on side surface of a conductive pad portion of a first groove of FIG. 3.

As shown in FIG. 4 to FIG. 6, the conductive pad portion 60 may include a first expansion pad 61 protruding from a first side of a width direction of the circuit line 42, and a second expansion pad 63 protruding from a second side of the width direction of the circuit line 42. In one or more embodiments, the first side and the second side are directions opposite to each other.

The first expansion pad 61 may protrude in a first side direction relative to a center of an end of the circuit line 42.

The first expansion pad 61 may be formed of a material the same as or similar to the material of the circuit line 42 and may protrude in a curved (e.g., round) shape in the first side direction while being connected to the circuit line 42.

The second expansion pad 63 may protrude from the circuit line 42 in a second side direction opposite to the first side direction in the same or similar shape as the first expansion pad 61 (e.g., the first expansion pad 61 and the second expansion pad 63 may be symmetric).

In one or more embodiments, the first expansion pad 61 and the second expansion pad 63, which are electrically connected to the end portion of the circuit line 42, each protrude in a curved (e.g., round) shape in opposite directions, and a first curved opening (e.g., round hole) 62 may be formed between the first expansion pad 61 and the second expansion pad 63.

As such, by forming the first round hole 62 between the first expansion pad 61 and the second expansion pad 63, a sufficient space for filling the solder 50 may be provided or obtained and a surface area of a portion applied with the solder 50 is increased, thereby achieving a more robust electrical connection.

As described above, when the first expansion pad 61 and the second expansion pad 63 are formed in the end portion of the circuit line 42, the application area of the solder 50 may be maximized or at least increased compared to a configuration in which the first expansion pad 61 and the second expansion pad 63 are not formed.

A conformal coating 70 (refer to FIG. 4) may be applied to a surface of the solder 50 connecting between the flexible printed circuit 30 and the DIP connector 40.

The conformal coating 70 may be applied to cover an entire outer surface (or substantially an entire outer surface) of the plurality of cured solders 50 to connect the flexible printed circuit 30 and the DIP connector 40.

The conformal coating 70 may be applied to the conductive pad portion 60 around the edge of the first groove 41 of the DIP connector 40 to entirely cover (or substantially entirely cover) the cured solder 50.

The conformal coating 70 is applied with a sufficient width to cover (or substantially cover) both a part of the DIP connector 40 and a part of the flexible printed circuit 30 around the first groove 41, and may be applied with a sufficient length along a length direction of the first groove 41 to entirely cover (or substantially entirely cover) the cured solder 50 at the conductive pad portion 60.

Accordingly, the conformal coating 70 may more stably maintain durability of (e.g., protect) the portion to which the solder 50 is applied.

In one or more embodiments, the rechargeable battery pack 100 may include a fixing pad portion 80 for fixing the flexible printed circuit 30 and the DIP connector 40 to each other.

The fixing pad part 80 may be formed to provide a fixing force such that the flexible printed circuit 30 and the DIP connector 40 are more stably fixed to each other.

That is, the fixing pad portion 80 is formed on the interconnected location of the flexible printed circuit 30 and the DIP connector 40 to be applied with the solder 50, and may more stably fix the flexible printed circuit 30 and the DIP connector 40 by the adherence of the solder 50.

The fixing pad portion 80 may be formed on a part of the first groove 41 of the DIP connector 40 in which the conductive pad portion 60 is located, and a side surface of a width direction of a part of the DIP connector 40, respectively.

The fixing pad portion 80 may fix the flexible printed circuit 30 and the DIP connector 40 by the adherence of the solder 50, at a portion where the circuit line 42 of the DIP connector 40 is not formed. That is, the solder 50 applied to the fixing pad part 80 provides fixing force by adhesive force rather than electrical connection between the flexible printed circuit 30 and the DIP connector 40.

In order to form the fixing pad portion 80 for fixing the flexible printed circuit 30 and the DIP connector 40, a second groove 43 may be further formed on the side surface of the DIP connector 40.

In one or more embodiments, the DIP connector 40 may include two second grooves 43. The second grooves 43 may be formed on opposite sides of the DIP connector 40 in the width direction.

Describing the fixing pad part 80 in more detail again, the fixing pad part 80 may include a first pad 81 formed in the first groove 41 and a second pad 83 formed in the second groove 43. The fixing pad part 80 may include a plural quantity (e.g., two or more) of second pads 83 in each of the second grooves 43.

The first pad 81 is formed in the first groove 41, and may be formed in a plural quantity (e.g., two or more) in the first groove 41 at a portion where the circuit line 42 of the DIP connector 40 is not formed.

Since the solder 50 is applied to the first pad 81, the DIP connector 40 and the flexible printed circuit 30 may be stably connected to each other by the adhesive force of the solder 50.

A second curved opening (e.g., round hole) 81a may be formed inside the first pad 81 to enlarge an area to which the solder 50 is applied.

The second round hole 81a may be formed in a substantially semicircular shape, such that the solder 50 may be applied to a sufficient contact area.

The first pads 81 are formed at locations spaced apart from a plurality of conductive pad portions 60 formed in the first groove 41, and may be formed at both side edge positions of the first groove 41.

That is, the first pads 81 may be formed on opposite sides of the first groove 41 with the plurality of conductive pad portions 60 interposed therebetween.

Therefore, the solder 50 is applied to conductive pad portions 60, and the first pad 81 may enable the electrical connection of the flexible printed circuit 30 and the DIP connector 40 to be more stably maintained.

Accordingly, the first pad 81 may be formed to prevent separation of the electrical connection between the flexible printed circuit 30 and the DIP connector 40, thereby increasing durability.

The first pad 81 may be formed in a single quantity or in a plural quantity at a position spaced apart from the plurality of conductive pad parts 60 in the first groove 41.

The first pad 81 is not necessarily limited to being formed at both edge positions of the first groove 41, and it is possible to be formed between the plurality of conductive pad parts 60 to provide a more effective fixing force.

The first groove 41 may be connected with an inclined groove 41a (see FIG. 6) connected to an edge of the DIP connector 40.

The inclined grooves 41a are formed on both sides of the first groove 41 and are formed in a straight line shape, and the first pad 81 may be formed on the inner wall surface thereof. Therefore, since the first pad 81 is formed in a plural quantity at locations close to the portion where the conductive pad unit 60 is formed, the flexible printed circuit 30 and the DIP connector 40 may be more stably interconnected to each other.

In one or more embodiments, the second pad 83 is formed on the inner wall surfaces of the second grooves 43 formed on opposite sides of the DIP connector 40 in the width direction, respectively, such that the connection of the flexible printed circuit 30 and the DIP connector 40 may be further secured.

The second pad 83 is formed in the second groove 43, and may be formed in a plural quantity in the second groove 43 at a portion where the circuit line 42 of the DIP connector 40 is not formed.

Since solder 50 is applied to the second pad 83, the DIP connector 40 and the flexible printed circuit 30 may be stably connected to each other by the adhesive force of the solder 50.

A third curved opening (e.g., round hole) 83a may be formed inside the second pad 83 to enlarge an area to which the solder 50 is applied.

The third round hole 83a may be formed in a substantially semicircular shape, such that the solder 50 may be applied to a sufficient contact area. That is, the third round hole 83a is formed in a shape similar to the second round hole 81a formed in the first pad 81, and they may be formed in a semicircular shape having the same or similar curvature to each other.

The second round hole 81a and the third round hole 83a are illustratively described as having the same or similar curvature to each other, but are not necessarily limited thereto, and it is possible to appropriately change the curvature in order to increase the fixing force of the flexible printed circuit 30 and the DIP connector 40 (e.g., the second round hole 81a and the third round hole 83a may have different shapes and/or different sizes). The second groove 43 is formed on opposite sides of the DIP connector 40 with a length shorter than the length of the first groove 41, and a plurality of second pads 83 may be formed on the inner wall surface thereof.

The formation of three second pads 83 on the inner wall surface of the second groove 43 will be described as an example. However, the present disclosure is not limited to three second pads 83 being formed on the inner wall surface of the second groove 43, and there may be any other suitable number of second pads 83 to change the size or fixing force of the DIP connector 40.

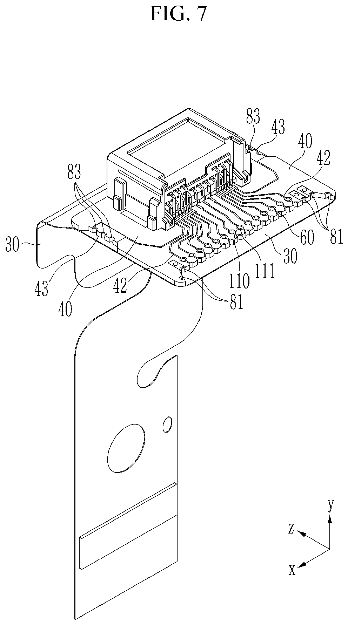

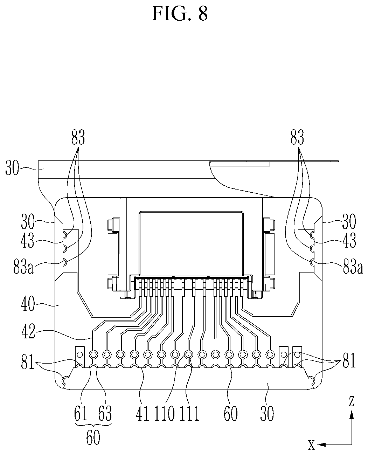

FIG. 7 is a perspective view schematically illustrating a configuration in which a conductive pad portion and a sub-pad portion are formed at an interconnection location of a flexible printed circuit and a DIP connector according to a second embodiment of the present disclosure. FIG. 8 is a top plan view schematically illustrating a configuration in which a conductive pad portion and a sub-pad portion are formed at an interconnection location of a flexible printed circuit and a DIP connector of FIG. 7. The same reference numerals as those in FIG. 1 to FIG. 6 denote the same or similar elements having the same or similar functions. In the following, the same reference numerals are not described in detail again.

As shown in FIG. 7 and FIG. 8, in a rechargeable battery pack according to a second embodiment of the present disclosure, in a plurality of circuit lines 42, a sub-pad portion 110 may be formed at locations spaced apart from the conductive pad portion 60.

The sub pad portion 110 is applied with solder 50 therein, and may be formed to electrically connect the DIP connector 40 and the flexible printed circuit 30 to each other.

The sub-pad portion 110 is formed to protrude from the circuit line 42 of the DIP connector 40 at a position spaced a certain distance from the conductive pad part 60, and a through hole 111 may be formed in the sub-pad portion 110.

The sub-pad portion 110 protrudes in a curved (e.g., round) shape from the circuit line 42 at a position spaced apart from the conductive pad part 60, and the sub-pad portion 110 may protrude while being electrically connected to the circuit line 42.

Although the sub-pad part 110 protrudes from the circuit line 42 in a round shape by way of example, it is not necessarily limited thereto and may be changed into various shapes including a polygonal shape.

As such, the solder 50 is inserted into the through hole 111 of the sub-pad portion 110 to electrically connect the flexible printed circuit board 30 and the DIP connector 40 to each other, thereby providing a more robust electrical connection.

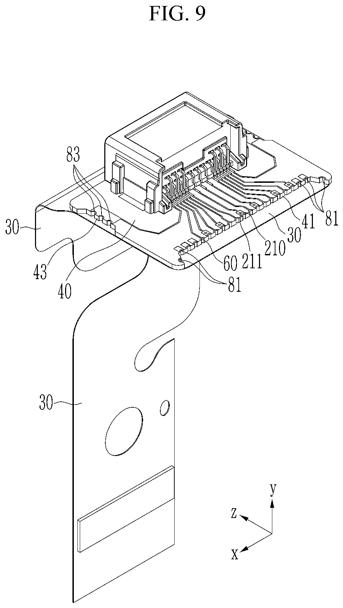

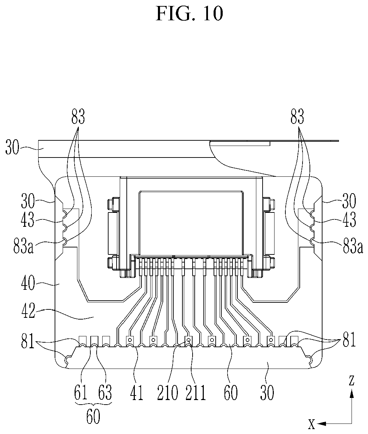

FIG. 9 is a perspective view schematically illustrating a configuration in which a conductive pad portion and a gas discharging portion are formed at an interconnection location of a flexible printed circuit and a DIP connector according to a third embodiment of the present disclosure. FIG. 10 is a top plan view schematically illustrating a configuration in which a conductive pad portion and a gas discharging portion are formed at an interconnection location of a flexible printed circuit and a DIP connector of FIG. 9. The same reference numerals as those in FIG. 1 to FIG. 8 denote similar elements having the same or similar functions, and detailed description thereof will be omitted below.

As shown in FIG. 9 and FIG. 10, the DIP connector 40 of a rechargeable battery pack according to a third embodiment of the present disclosure may have a gas discharging portion 210 formed at a location spaced apart from the conductive pad portion 60.

The gas discharging portion 210 is connected to a part of the plurality of circuit lines 42 at a side surface position of the conductive pad portion 60, and may be applied as a third pad having a gas discharge hole 211 formed therein. Hereinafter, the same reference numerals are used for the gas discharge unit and the third pad.

A third pad 210 is formed on the DIP connector 40 at a side surface position of the conductive pad part 60, and it may be formed on a portion of the plurality of circuit lines 42 formed on the DIP connector 40.

The gas discharge hole 211 may be formed in the third pad 210.

The gas discharge hole 211 is described as being formed in a single quantity in the third pad 210, but is not necessarily limited thereto and may be formed in a plural quantity (e.g., there may be two or more gas discharge holes 211).

Therefore, gas generated in the process of connecting the DIP connector 40 and the flexible printed circuit 30 to each other by applying the solder 50 to the conductive pad portion 60 may be easily discharged through the gas discharge hole 211 to the outside. Accordingly, the fixing force by the solder 50 is further improved, and durability of electrical connection between the DIP connector 40 and the flexible printed circuit 30 may be improved.

The third pad 210 has a generally rectangular planar shape and may be formed at the side surface of the conductive pad unit 60. The third pad 210 is not necessarily limited to a rectangular planar shape, and in one or more embodiments a portion or the entire edge of the third pad 210 may also include a curved (e.g., round) shape.

The third pad 210 may be formed on some of the plurality of circuit lines 42 formed in the DIP connector 40 (e.g., the third pad 210 may not be applied to each of the circuit lines 42). In one or more embodiments, the third pad 210 may be formed on alternate circuit lines 42 (e.g., the third pad 210 may be on every other circuit line 42), such as an even-numbered circuit line or an odd-numbered circuit line among the plurality of circuit lines 42.

Therefore, since the gas generated in the process of applying and curing the solder 50 may be easily discharged to the outside through the gas discharge hole 211, the fixing force by the solder 50 is further improved and durability of the electrical connection of the flexible printed circuit 30 and the DIP connector 40 may be improved.

While this invention has been described in connection with what is presently considered to be practical embodiments, it is to be understood that the invention is not limited to the disclosed embodiments, but, on the contrary, is intended to cover various modifications and equivalent arrangements included within the scope of the appended claims.

### Description of symbols

| | | | |
|---|---|---|---|
| 10: | cell assembly | 11: | battery cell |
| 20: | frame portion | 21: | first side frame |
| 22: | second side frame | 23: | first end frame |
| 24: | second end frame | 30: | flexible printed circuit |
| 40: | DIP connector | 41: | first groove |
| 41a: | inclined groove | 42: | circuit line |
| 43: | second groove | 50: | electrically conductive adhesive, solder |
| 60: | conductive pad portion | 61: | first expansion pad |
| 62: | first round hole | 63: | second expansion pad |
| 70: | conformal coating | 80: | fixing pad portion |
| 81: | first pad | 81a: | second round hole |
| 83: | second pad | 83a: | third round hole |
| 110: | sub-pad portion | 111: | through hole |
| 210: | gas discharging portion, third pad | | |
| 211: | gas discharging hole | | |

## Claims

1. A rechargeable battery pack, comprising:
a cell assembly including at least one battery cell;
a frame portion accommodating the cell assembly;
a flexible printed circuit (FPC) electrically connected to the cell assembly, and configured to sense at least one property of the battery cell; and
a dual-in-line plug (DIP) connector electrically connected to the flexible printed circuit on a first side of the frame portion,
wherein the flexible printed circuit and the DIP connector are electrically connected to each other by an electrically conductive adhesive.

2. The rechargeable battery pack of claim 1, wherein the electrically conductive adhesive is a solder or conductive glue that electrically connects the flexible printed circuit and the DIP connector.

3. The rechargeable battery pack of claim 2, wherein the DIP connector comprises a plurality of circuit lines and a plurality of conductive pad portions at end portions of the plurality of circuit lines, and wherein the plurality of conductive pad portions are electrically connected to the flexible printed circuit by the electrically conductive adhesive.

4. The rechargeable battery pack of claim 3, wherein at least one conductive pad portion of the plurality of conductive pad portions comprises:
a first expansion pad protruding from a first side of a width direction of a circuit line of the plurality of circuit lines; and
a second expansion pad protruding from a second side of the width direction of the circuit line.

5. The rechargeable battery pack of claim 4, wherein the first expansion pad and the second expansion pad protrude from an end portion of the circuit line, in a round shape in directions facing each other.

6. The rechargeable battery pack of claim 5, further comprising a first round hole between the first expansion pad and the second expansion pad.

7. The rechargeable battery pack of claim 6, wherein the electrically conductive adhesive comprises a solder or wire solder in the first round hole.

8. The rechargeable battery pack of claim 7, further comprising a first groove in the DIP connector, and wherein the conductive pad portion is in the first groove, wherein a rear side surface of the DIP connector is in surface contact with a surface of the flexible printed circuit, and wherein the first groove is on a first side surface of the DIP connector.

9. The rechargeable battery pack of claim 8, further comprising a fixing pad portion fixing the flexible printed circuit and the DIP connector to each other, and
a second groove at each of opposite sides of a width direction of the DIP connector, wherein the fixing pad portion is in the second groove.

10. The rechargeable battery pack of claim 9, wherein the fixing pad portion fixes the flexible printed circuit and the DIP connector by the electrically conductive adhesive at a portion where the plurality of circuit lines is not formed, and wherein the fixing pad portion comprises:
a first pad in the first groove; and
a second pad in the second groove.

11. The rechargeable battery pack of claim 10, further comprising a second round hole in the first pad, the second round hole having a first curvature, optionally wherein the rechargeable battery pack further comprises a third round hole in the second pad, the third round hole having a second curvature different from the first curvature.

12. The rechargeable battery pack of any one of claims 10 and 11, further comprising, in at least one circuit line among the plurality of circuit lines formed in the DIP connector, a sub-pad portion at a position spaced apart from the conductive pad portion and electrically interconnecting the DIP connector and the flexible printed circuit, optionally wherein the rechargeable battery pack further comprises a through hole in an interior of the sub-pad portion into which the electrically conductive adhesive is inserted, and wherein the at least one circuit line protrudes to both sides in the width direction.

13. The rechargeable battery pack of any one of claims 10 and 11, further comprising a gas discharging portion in the DIP connector spaced apart from the conductive pad portion.

14. The rechargeable battery pack of claim 13, wherein the gas discharging portion comprises a third pad connected to the plurality of circuit lines on a side surface of the conductive pad portion, and
wherein the third pad is at the side surface of the conductive pad portion, and wherein the third pad has a width larger than a width of each of the plurality of circuit lines, optionally wherein the gas discharging hole penetrates both the third pad and the DIP connector.

15. The rechargeable battery pack of any one of claims 8 to 14, further comprising a conformal coating on a surface of the electrically conductive adhesive, optionally wherein the conformal coating covers the conductive pad portion around the first groove of the DIP connector.
